(19) Europäisches Patentamt
European Patent Office
Office européen des brevets

(11) **EP 4 709 077 A2**

(12) **EUROPEAN PATENT APPLICATION**

(43) Date of publication:
**11.03.2026 Bulletin 2026/11**

(21) Application number: **25198732.7**

(22) Date of filing: **28.08.2025**

(51) International Patent Classification (IPC):
**H10B 63/10** (2023.01)

(52) Cooperative Patent Classification (CPC):
**H10N 70/026; H10B 63/84; H10B 63/845;
H10N 70/25; H10N 70/823; H10N 70/826;
H10N 70/8825**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **29.08.2024  KR 20240016941
27.08.2025  KR 20250120571**

(71) Applicant: **Samsung Electronics Co., Ltd.
Suwon-si, Gyeonggi-do 16677 (KR)**

(72) Inventors:
• **KANG, Youngjae
16678 Suwon-si (KR)**
• **KOO, Bonwon
16678 Suwon-si (KR)**
• **SUNG, Hajun
16678 Suwon-si (KR)**
• **YANG, Kiyeon
16678 Suwon-si (KR)**
• **WU, Zhe
16677 Suwon-si (KR)**
• **CHAE, Hwasung
16677 Suwon-si (KR)**
• **CHOI, Minwoo
16678 Suwon-si (KR)**

(74) Representative: **Elkington and Fife LLP
Prospect House
8 Pembroke Road
Sevenoaks, Kent TN13 1XR (GB)**

(54) **MEMORY DEVICE, ELECTRONIC DEVICE INCLUDING THE SAME, AND METHOD OF MANUFACTURING MEMORY DEVICE**

(57) Provided are a memory device including oxygen and chalcogenide, an electronic device including the memory device, and a method of manufacturing the memory device. The memory device may include a plurality of bit lines extending in a first direction, a plurality of word lines extending in a second direction, wherein the second direction may cross the first direction, and a memory layer at points where the plurality of bit lines and the plurality of word lines cross each other. The memory layer may have a characteristic in which a threshold voltage changes depending on a polarity and an intensity of an applied voltage. The memory layer may include Ge, As, Se, In, and O.

FIG. 2

EP 4 709 077 A2

# EP 4 709 077 A2

## Description

### FIELD OF THE INVENTION

The disclosure relates to a memory device including oxygen and chalcogenide, an electronic device including the memory device, and/or a method of manufacturing the memory device.

### BACKGROUND OF THE INVENTION

Due to the development of electronic products that may be increasingly lightweight, thinner, and/or simpler, the demand for highly integrated memory devices may be increasing. In a memory device having a cross-point structure, word lines and bit lines vertically cross each other, and memory cells may be arranged in regions in which the word lines and the bit lines cross each other. This structure may provide a small memory cell size in a plan view. In general, memory cells having a cross-point structure include a 2-terminal selector and a memory device that are connected in series to each other to limit and/or prevent the occurrence of a sneak current between adjacent memory cells. Generally, a memory device may include a memory and a selector that selects the memory. However, recently, self-selecting memory (SSM) devices having both the function of the selector and the function of the memory device have been developed. SSM devices may miniaturize memory devices by implementing the memory and the selector in a single device.

### SUMMARY OF THE INVENTION

Provided is a memory device including a self-selecting memory material.

Provided is an electronic device including a memory device.

Provided is a method of manufacturing a memory device including a self-selecting memory material.

Additional aspects will be set forth in part in the description which follows and, in part, will be apparent from the description, or may be learned by practice of the presented embodiments of the disclosure.

According to an example embodiment of the disclosure, a memory device may include a plurality of bit lines extending in a first direction; a plurality of word lines extending in a second direction, wherein the second direction crosses the first direction; and a memory layer at points where the plurality of bit lines and the plurality of word lines cross each other. The memory layer may have a characteristic in which a threshold voltage changes depending on a polarity and an intensity of an applied voltage. The memory layer may include Ge, As, Se, In, and O. A content of In in the memory layer may be greater than 0 at% and less than or equal to 7 at%.

A material composition thus is proposed that improves leakage current and Vth drift characteristics while maintaining a memory window (MW). Predictive simulations of amorphous materials showed that oxygen doping reduced leakage current by 85% compared to undoped materials, indicating that oxygen is an effective dopant. Electrically favorable chalcogenide materials may be composed of germanium (Ge), arsenic (As), selenium (Se), a Group 4 metal (M), and oxygen. The oxygen content is maintained at low levels, within 10%, to prevent oxidation of the chalcogenide matrix. During target fabrication, oxygen doping should also be kept below 3%, preferably controlled via GeO. Due to its trace amount, precise quantification of oxygen may be challenging. Oxygen helps control drift by forming stable Ge-O bonds instead of unstable Ge-Ge wrong bonds. When, if the oxygen content exceeds 5%, material degradation such as increased leakage current may occur. Therefore, a preferred doping level may be within 3%. In a Ge-mid region, the effect of drift improvement has been observed with or without oxygen doping. The memory window may also be either slightly increased or maintained, and leakage current improved. A preferable composition includes up to 25% Ge, up to 65% Se, up to 40% As, 10% In, and up to 5% oxygen.

According to a preferred embodiment, there may be proposed a self-selecting memory comprising a material comprising Ge, As, Se, In, and O.

In some embodiments, a content of O in the memory layer may be greater than 1 at% and less than or equal to 10 at%. In some embodiments, the oxygen content may be within 10 at%, and preferably within 5 at%.

In some embodiments, a content of Ge in the memory layer may be 10 at% or more and 40 at% or less, a content of Se in the memory layer may be 30 at% or more and 70 at% or less, and a content of As in the memory layer may be 15 at% or more and 40 at% or less.

In some embodiments, the memory layer may further include at least one of S, Sb, Al, and Ga in an amount of 10 at% or less.

In some embodiments, the memory layer may have either a first state having a first threshold voltage or a second state having a second threshold voltage, and the second threshold voltage may be higher than the first threshold voltage.

According to an example embodiment of the disclosure, a memory device may include a plurality of word planes spaced apart from each other in a third direction, the third direction being perpendicular to a plane including a first direction and a second direction crossing each other; a plurality of vertical bit lines penetrating the plurality of word planes and extending in the third direction; and a memory cell string surrounding the plurality of vertical bit lines and extending in the third direction, wherein the memory cell string may have a characteristic in which a threshold voltage changes depending on a polarity and an intensity of an applied voltage. The memory cell string may include Ge, As, Se, In, and O. A content of In in the memory cell string may be greater than 0 at% and less than or equal to 7 at%.

In some embodiments, a content of O in the memory cell string may be greater than 1 at% and less than or equal to 10 at%.

In some embodiments, a content of Ge in the memory cell string may be 10 at% or more and 40 at% or less, a content of Se in the memory cell string may be 30 at% or more and 70 at% or less, and a content of As in the memory cell string may be 15 at% or more and 40 at% or less.

In some embodiments, the memory cell string may further include at least one of S, Sb, Al, and Ga in an amount of 10 at% or less.

In some embodiments, the memory cell string may have either a first state having a first threshold voltage or a second state having a second threshold voltage, and the second threshold voltage may be higher than the first threshold voltage.

According to an example embodiment, an electronic device may include a memory device; and a memory controller configured to control the memory device. The memory device may include a plurality of bit lines extending in a first direction, a plurality of word lines extending in a second direction, and a memory layer at points where the plurality of bit lines and the plurality of word lines cross each other. The second direction may cross the first direction. The memory layer may have a characteristic in which a threshold voltage changes depending on a polarity and an intensity of an applied voltage. The memory layer may include Ge, As, Se, In, and O. A content of In in the memory layer may be greater than 0 at% and less than or equal to 7 at%.

According to an example embodiment, a method of manufacturing a memory device may include preparing at least one target including at least one of Ge, As, Se, and In in a chamber; preparing a target including GeO in the chamber; sputtering each of the at least one target and the target including GeO in a gas atmosphere; controlling a deposition amount of O in the target including GeO; and forming a memory layer including Ge, As, Se, In, and O from the at least one target and the target including GeO. A content of In in the memory layer may be greater than 0 at% and less than or equal to 7 at%.

In some embodiments, the preparing of the at least one target may include preparing a first target including Ge, As, and Se and preparing a second target including In.

In some embodiments, the preparing of the at least one target may include preparing a target including Ge, As, Se, and In.

In some embodiments, a content of O in the memory layer may be greater than 1 at% and less than or equal to 10 at%.

In some embodiments, a content of Ge in the memory layer may be 10 at% or more and 40 at% or less, a content of Se may be 30 at% or more and 70 at% or less, and a content of As may be 15 at% or more and 40 at% or less.

In some embodiments, the memory layer may further include at least one of S, Sb, Al, and Ga in an amount of 10 at% or less.

In some embodiments, the method may further include pattering the memory layer to provide a patterned memory layer; and connecting an electrode to both ends of the patterned memory layer.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a cross-sectional view schematically illustrating a structure of a memory device according to an embodiment;
FIG. 2 is a graph illustrating voltage-current characteristics of a memory layer of a memory device according to an embodiment;
FIG. 3A is a graph illustrating bias voltages for a "1" write operation (a SET operation) and a read operation in a memory device according to an embodiment.
FIG. 3B is a graph illustrating bias voltages for a "0" write operation (a RESET operation) and a read operation in a memory device according to an embodiment;
FIG. 4A is a conceptual diagram illustrating a trap state inside a memory layer in a pristine state of a memory layer of a memory device according to an embodiment;
FIG. 4B schematically illustrates an energy band diagram of a memory layer in a pristine state of a memory layer of a memory device according to an embodiment;
FIG. 5A is a conceptual diagram illustrating a trap state inside a memory layer after a positive (+) bias voltage for first-firing is applied to a memory layer in a pristine state;
FIG. 5B schematically illustrates an energy band diagram of a region of a memory layer near a first electrode after first-firing;

FIG. 5C schematically illustrates an energy band diagram of a region of a memory layer near a second electrode after first-firing;

FIG. 6A is a conceptual diagram illustrating a trap state inside a memory layer after a negative (-) bias voltage is applied to a first-fired memory layer;

FIG. 6B schematically illustrates an energy band diagram of a memory layer region near a first electrode after a negative bias voltage is applied;

FIG. 6C schematically illustrates an energy band diagram of a memory layer region near a second electrode after a negative bias voltage is applied;

FIG. 7 schematically illustrates a band diagram of a space charge region formed by a RESET operation in a memory device according to an embodiment;

FIG. 8 illustrates a V-I curve showing that a memory window is generated in a memory device according to an embodiment by simulating a result shown in FIG. 7;

FIG. 9A illustrates a change in a threshold voltage according to oxygen (O) concentration of a semiconductor device according to an embodiment;

FIG. 9B illustrates a change in Vth_drift according to oxygen (O) concentration of a semiconductor device according to an embodiment;

FIG. 9C illustrates a change in the memory window $\Delta$Vth according to oxygen (O) concentration of a semiconductor device according to an embodiment;

FIG. 10A illustrates a change in a threshold voltage Vth with respect to a writing voltage Vw when oxygen (O) concentration is 0 in a comparative example;

FIG. 10B illustrates a change in threshold voltage Vth with respect to a writing voltage Vw when oxygen (O) concentration is 1.5 at% in an embodiment;

FIG. 10C illustrates a change in threshold voltage Vth with respect to a writing voltage Vw when oxygen (O) concentration is 3 at% in an embodiment;

FIG. 10D illustrates a change in threshold voltage Vth with respect to writing voltage Vw when oxygen (O) concentration is 5 at% in an embodiment;

FIG. 11 illustrates a distribution of memory window $\Delta$Vth and Vth_drift according to the Ge-As-Se-In-O composition;

FIG. 12 is a drawing for explaining a method of manufacturing a memory device according to an embodiment;

FIG. 13 illustrates an example of a method of manufacturing a memory device according to FIG. 12;

FIG. 14 illustrates an example of a method of manufacturing a memory device according to FIG. 12;

FIG. 15 is a drawing for explaining a method of manufacturing a memory device according to another embodiment;

FIG. 16 is a perspective view schematically illustrating a structure of a memory device according to an embodiment;

FIG. 17 is a plan view illustrating an operation in which the memory device shown in FIG. 16 selects a specific memory cell;

FIG. 18 is a perspective view schematically illustrating a structure of a memory device according to another embodiment;

FIG. 19 is a vertical cross-sectional view schematically illustrating a structure of one memory cell in the memory device illustrated in FIG. 18;

FIG. 20 is a horizontal cross-sectional view schematically illustrating a structure of one memory cell in the memory device shown in FIG. 18;

FIG. 21 is a conceptual diagram schematically illustrating a device architecture applicable to an electronic device according to an embodiment;

FIG. 22 is a block diagram of a memory system according to an embodiment; and

FIG. 23 is a block diagram illustrating a neuromorphic apparatus and an external device connected thereto, according to an embodiment.

## DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, "at least one of A, B, and C," and similar language (e.g., "at least one selected from the group consisting of A, B, and C," "at least one of A, B, or C") may be construed as A only, B only, C only, or any combination of two or more of A, B, and C, such as, for instance, ABC, AB, BC, and AC.

When the terms "about" or "substantially" are used in this specification in connection with a numerical value, it is intended that the associated numerical value includes a manufacturing or operational tolerance (e.g., $\pm 10\%$) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., $\pm 10\%$) around the stated numerical values or shapes. When ranges are specified, the range includes all values therebetween such as increments of 0.1%.

While the term "equal to" is used in the description of example embodiments, it should be understood that some imprecisions may exist. Thus, when one element is referred to as "equal to" another element, it should be understood that an element or a value may be "equal to" another element within a desired manufacturing or operational tolerance range (e.g., $\pm 10\%$).

The notion that elements are "substantially the same" may indicate that the element may be completely the same and may also indicate that the elements may be determined to be the same in consideration of errors or deviations occurring during a process.

Hereinafter, a self-selecting memory material, a memory device, and an electronic device including the self-selecting memory material, and a method of manufacturing a memory device according to various embodiments are described in detail with reference to the accompanying drawings. In the drawings, like reference numerals in the drawings denote like elements, and sizes of components in the drawings may be exaggerated for clarity and convenience of explanation. While such terms as "first," "second," etc., may be used to describe various components, such components must not be limited to the above terms. The terms are used only to distinguish one component from another.

An expression used in the singular encompasses the expression of the plural, unless it has a clearly different meaning in the context. When a portion "includes" an element, another element may be further included, rather than excluding the existence of the other element, unless otherwise described. Sizes or thicknesses of components in the drawings may be arbitrarily exaggerated for convenience of explanation. Further, when a certain material layer is described as being disposed on a substrate or another layer, the material layer may be in contact with the substrate or the other layer, or there may be a third layer between the material layer and the substrate or the other layer. In the following embodiments, materials constituting each layer are provided merely as an example, and other materials may also be used.

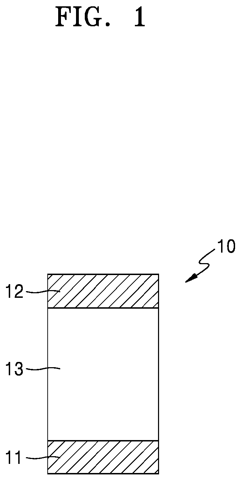

FIG. 1 is a cross-sectional view schematically illustrating a structure of a memory device 10 according to an embodiment.

Referring to FIG. 1, the memory device 10 may include a first electrode 11, a second electrode 12 disposed apart from the first electrode 11, and a memory layer 13 disposed between the first electrode 11 and the second electrode 12.

The first electrode 11 and the second electrode 12 may have a function of applying a voltage to the memory layer 13. To this end, each of the first electrode 11 and the second electrode 12 may independently include a metal, a conductive metal nitride, a conductive metal oxide, or a combination thereof. For example, the first electrode 11 and the second electrode 12 may each include at least one of titanium nitride (TiN), titanium Silicon Nitride (TiSiN), titanium carbon nitride (TiCN), titanium Carbon Silicon Nitride (TiCSiN), titanium aluminum nitride (TiAlN), tantalum (Ta), tantalum nitride (TaN), tantalum silicon nitride (TaSiN), tantalum aluminum nitride (TaAlN), tungsten silicide (WSi), titanium tungsten (TiW), molybdenum nitride (MoN), niobium nitride (NbN), titanium boron nitride (TiBN), zirconium silicon nitride (ZrSiN), tungsten silicon nitride (WSiN), tungsten boron nitride (WBN), zirconium aluminum nitride (ZrAlN), molybdenum aluminum nitride (MoAlN), titanium aluminum (TiAl), titanium oxynitride (TiON), Titanium aluminum oxynitride (TiAlON), Tungsten oxynitride (WON), tantalum oxynitride (TaON), silicon carbide (SiC), silicon carbon nitride (SiCN), carbon nitride (CN), tantalum carbonitride (TaCN), tungsten (W), tungsten nitride (WN), carbon (C), or a combination thereof. In an example, the first electrode 11 and the second electrode 12 may include the same material, but are not limited thereto, and in another example, the first electrode 11 and the second electrode 12 may include different materials.

The memory layer 13 may have ovonic threshold switching (OTS) characteristics in which the memory layer 13 has a high-resistance state when a voltage lower than a threshold voltage (e.g., a voltage with a lower absolute value) is applied to the memory layer 13 and has a low-resistance state when a voltage higher than the threshold voltage (e.g., a voltage with a higher absolute value) is applied to the memory layer 13. The memory device 10 may perform a selector function by using the OTS characteristics. In addition, the memory layer 13 may have memory characteristics in which the threshold voltage shifts depending on a polarity and an intensity of a bias voltage applied to the memory layer 13. The memory device 10 may perform a memory function by utilizing a change in threshold voltage. Therefore, the memory device 10 may have characteristics of a self-selecting memory capable of performing both a memory function and a selector function with only a single memory layer 13.

As described above, the memory layer 13 may have ovonic threshold switching characteristics, and may include a material whose threshold voltage changes depending on a polarity and an intensity of an applied voltage. For example, the memory layer 13 may include Ge, As, Se, In, and O. Ge may enhance the thermal stability of the memory device 10, As may enhance the stability of an amorphous structure, and Se may increase an energy bandgap. Oxygen (O) may reduce the Vth_drift of the memory device 10, and suppress or improve the reduction of a memory window. The selector element experiences a Vth shift, which is a change in threshold voltage during repeated switching, due to the influence of traps existing in the energy band region. At this time, the slope of the Vth change according to the delay time may be defined as Vth_drift. In general, Vth_drift and memory window have a trade-off relationship, so when Vth_drift decreases, the memory window decreases, or when Vth_drift increases, the memory window increases, making it difficult to satisfy both characteristics. However, the memory layer 13 of the memory device 10 according to an embodiment may include oxygen, thus may improve both Vth_drift and memory window characteristics, or may improve Vth_drift and limit and/or suppress a decrease in the memory window characteristics. This will be described in more detail below.

The content of In included in the memory layer 13 may be greater than about 0 at% and 7 at% or less. The content of Ge included in the memory layer 13 may be about 10 at% or more and about 40 at% or less. Alternatively, the content of Ge may be about 13 at% or more and about 36 at% or less. Alternatively, the content of Ge may be about 15 at% or more and about 33 at% or less. The content of Se included in the memory layer 13 may be about 30 at% or more and about 70 at% or less. Alternatively, the content of Se may be about 33 at% or more and about 67 at% or less. Alternatively, the content of Se may be about 37 at% or more and about 62 at% or less. The content of As included in the memory layer 13 may be about 15 at% or more and about 40 at% or less. Alternatively, the content of As may be about 18 at% or more and about 37 at% or less. Alternatively, the content of As may be about 21 at% or more and about 34 at% or less. The content of O included in the memory layer 13 may be greater than about 1 at% and less than or equal to about 10 at%. Alternatively, the O content may be greater than about 1 at% and less than or equal to about 5 at%. The oxygen (O) may be included as a dopant in the memory layer 13. The oxygen may be combined with Ge of the memory layer 13 to form a stable Ge-O bond instead of an unstable Ge-Ge bond, thereby controlling Vth_drift, enhancing the stability of the memory device 10, and increasing the reliability of the memory device 10.

Meanwhile, the memory layer 13 may further include a dopant. For example, the memory layer 13 may further include at least one of S, Sb, Al, and Ga in an amount of 10 at% or less. This makes it easier to control Vth_drift.

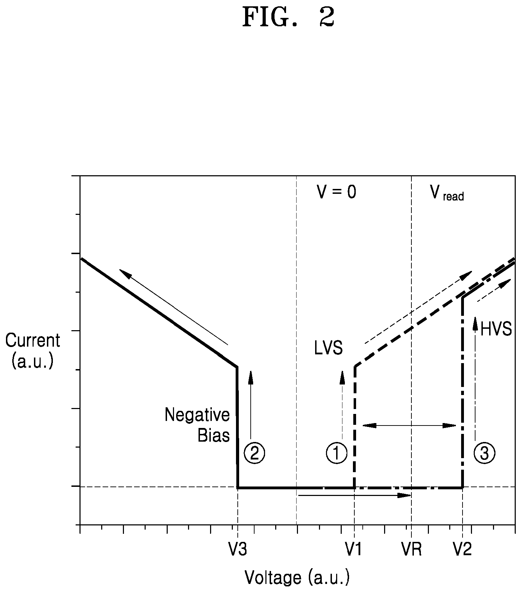

FIG. 2 is a graph illustrating voltage-current characteristics of the memory layer 13 of the memory device 10 according to an embodiment. Referring to FIG. 2, the memory layer 13 may have one of a first state (low Vth state (LVS)) in which a threshold voltage is relatively low and a second state (high Vth state (HVS)) in which the threshold voltage is relatively high. For example, in the first state, the threshold voltage of the memory layer 13 may be a first voltage V1, and in the second state, the threshold voltage of the memory layer 13 may be a second voltage V2 that is greater than the first voltage V1. When the memory layer 13 is in the first state, as a voltage less than the first voltage V1 is applied to the memory layer 13, substantially no current flows between both ends of the memory layer 13, and when a voltage greater than the first voltage V1 is applied to the memory layer 13, the memory layer 13 turns on and current flows through the memory layer 13. In addition, when the memory layer 13 is in the second state, as a voltage less than the second voltage V2 is applied to the memory layer 13, substantially no current flows between both ends of the memory layer 13, and when a voltage greater than the second voltage V2 is applied to the memory layer 13, the memory layer 13 turns on and current flows through the memory layer 13.

Therefore, a voltage between the first voltage V1 and the second voltage V2 may be selected as a read voltage VR. When the memory layer 13 is in the first state, as the read voltage VR is applied to the memory layer 13, current flows through the memory layer 13. At this time, a data value stored in the memory layer 13 may be defined as a first binary value or a first logical value "1." When the memory layer 13 is in the second state, as the read voltage VR is applied to the memory layer 13, substantially no current flows through the memory layer 13. At this time, a data value stored in the memory layer 13 may be defined as a second binary value or a second logical value "0." In other words, the data value stored in the memory layer 13 may be read by measuring the current flowing through the memory layer 13 while applying the read voltage VR to the memory layer 13.

Meanwhile, when the memory layer 13 is in the first state, as a negative (-) bias voltage is applied to the memory layer 13, the threshold voltage of the memory layer 13 may increase and the memory layer 13 may transition to the second state. For example, when a negative third voltage V3 is applied to the memory layer 13, the memory layer 13 may transition to the second state. This operation may be referred to as a 'RESET' operation or an erase operation. In addition, when the memory layer 13 is in the second state, as a positive (+) bias voltage greater than the second voltage V2 is applied to the memory layer 13, the threshold voltage of the memory layer 13 may decrease and the memory layer 13 may transition to the first state. This operation may be referred to as a 'SET' operation or a program operation. A difference between the second voltage V2, which is a RESET threshold voltage, and the first voltage V1, which is a SET threshold voltage, corresponds to a memory window.

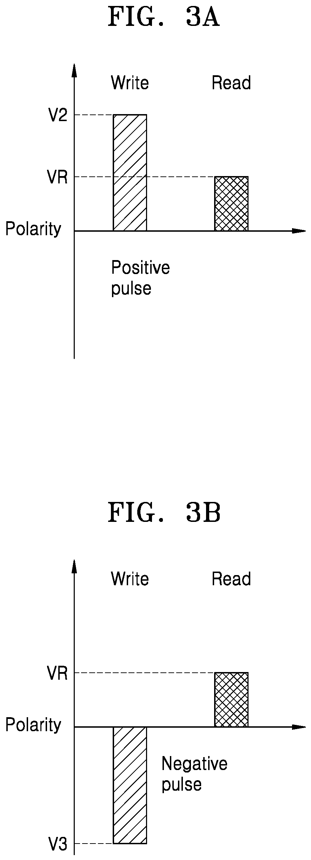

FIG. 3A is a graph illustrating bias voltages for a SET operation and a read operation of the memory device 10 according to an embodiment. Referring to FIG. 3A, in the SET operation, a positive bias voltage (a positive pulse) greater than or equal to the second voltage V2 may be applied to the memory layer 13. Then, the threshold voltage of the memory layer 13 may be shifted to the first voltage V1. Thereafter, in the read operation, a positive read voltage VR between the first voltage V1 and the second voltage V2 may be applied to the memory layer 13. When a read voltage VR is applied, the memory layer 13 may be turned on.

FIG. 3B is a graph illustrating bias voltages for a RESET operation and a read operation of the memory device 10 according to an embodiment. Referring to FIG. 3B, in the RESET operation, a negative bias voltage (a negative pulse), that is, a third voltage V3, may be applied to the memory layer 13. The absolute value of the third voltage V3 may be approximately equal to or slightly greater or less than the second voltage V2. Then, a threshold voltage of the memory layer 13 may be shifted to the second voltage V2 that is greater than the first voltage V1. Thereafter, in the read operation, a positive read voltage VR between the first voltage V1 and the second voltage V2 may be applied to the memory layer 13. When the read voltage VR is applied to the memory layer 13, the memory layer 13 may be turned off.

As described above, the memory layer 13 of the memory device 10 according to an embodiment may have ovonic threshold switching characteristics and may also have memory characteristics in which the threshold voltage of the memory layer 13 varies. In other words, the memory device 10 may be configured to function as both a memory and a selector. The threshold voltage of the memory layer 13 may be shifted according to a polarity of a bias voltage applied to the memory layer 13. In this regard, the memory device 10 according to an embodiment may be a self-selecting memory device having polarity dependent on threshold voltage shift characteristics.

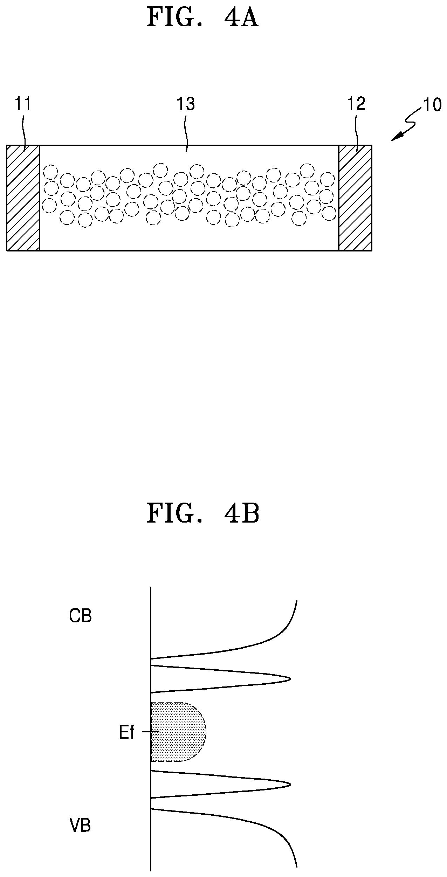

Such polarity dependent threshold voltage shift behavior may be explained through a change in a trap state inside the memory layer 13. FIGS. 4A to 6B are for conceptually describing a change in a trap state inside the memory layer 13.

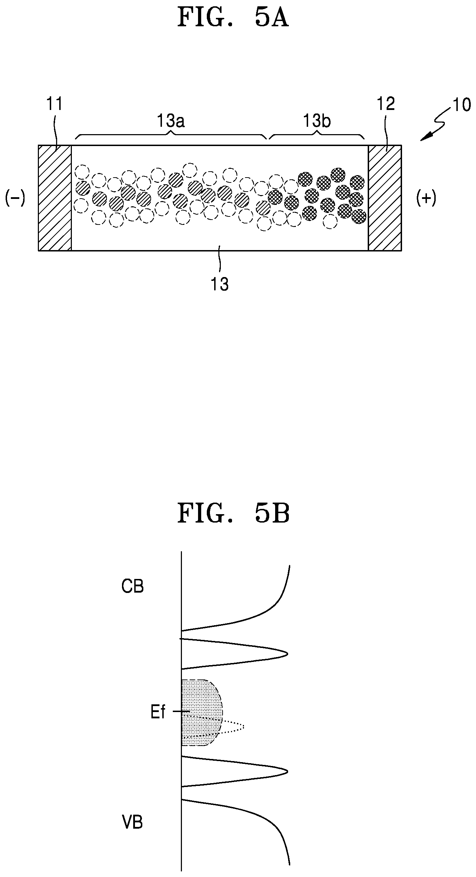

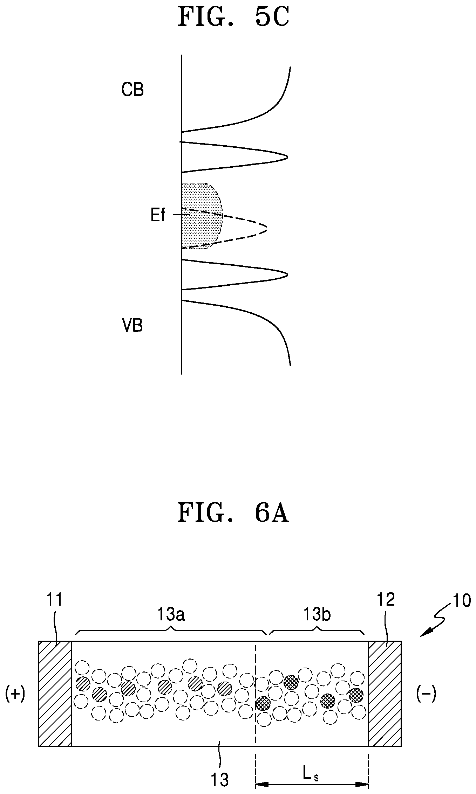

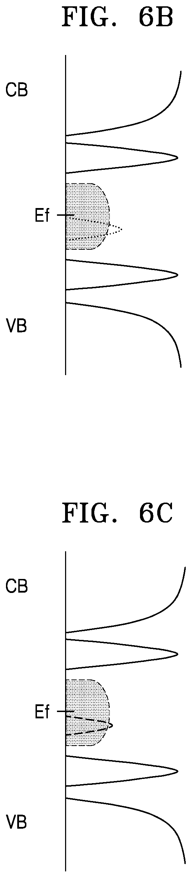

FIG. 4A is a conceptual diagram illustrating a trap state inside a memory layer in a pristine state of the memory layer 13 of the memory device 10 according to an embodiment. FIG. 4B schematically illustrates an energy band diagram of the memory layer 13 in the pristine state. FIG. 5A is a conceptual view illustrating a trap state inside the memory layer 13 after a positive (+) bias voltage for first-firing is applied to the memory layer 13 in the pristine state. FIG. 5B schematically illustrates an energy band diagram of a region of the memory layer 13 near the first electrode 11 after first-firing. FIG. 5C schematically illustrates an energy band diagram of a region of the memory layer 13 near the second electrode 12 after first-firing. FIG. 6A is a conceptual diagram illustrating a trap state inside the memory layer 13 after a negative (-) bias voltage is applied to the first fired memory layer 13. FIG. 6B schematically illustrates an energy band diagram of a region of the memory layer 13 near the first electrode 11 after a negative bias voltage is applied. FIG. 6C schematically illustrates an energy band diagram of a region of the memory layer 13 near the second electrode 12 after a negative bias voltage is applied.

Referring to FIG. 4A, de-activated traps are mainly present in the memory layer 13 immediately after being manufactured in the pristine state. For convenience of description, the de-activated traps are indicated by dotted circles in FIG. 4A. The de-activated traps may be mainly formed by covalent bonds between atoms adjacent to each other in the memory layer 13.

In addition, in the graph of FIG. 4B, 'CB' denotes a conduction band, 'VB' denotes a valence band, and a horizontal axis represents a density of state. Referring to FIG. 4B, an energy band formed by de-activated traps is indicated by a thin dashed line. An energy band indicated by a solid line in FIG. 4B is formed of materials other than traps in the memory layer 13. The energy band formed by the de-activated traps may be distributed around the Fermi level Ef.

A positive (+) bias voltage may be applied to first-fire the memory layer 13 in the pristine state. For example, a bias voltage may be applied to the memory layer 13 so that current flows from the second electrode 12 to the first electrode 11. Referring to FIG. 5A, some of the de-activated traps may be activated by first-firing to form activated traps. A percolation path or a conduction path may be formed in the memory layer 13 by such activated traps, and a threshold voltage of the memory layer 13 may be decreased by forming the percolation path. Conversely, when the density of state of the activated trap is low, the percolation path may be reduced, and thus the threshold voltage of the memory layer 13 may be increased.

In FIG. 5A, activated traps are represented by a circle of a comb pattern and a circle of a network pattern. As shown in FIG. 5A, the amount of activated traps in the memory layer 13 may increase from the first electrode 11 to the second electrode 12. In particular, a large amount of activated traps may be generated in a region of the memory layer 13 close to the second electrode 12. Therefore, after first-firing, the memory layer 13 may include a first region 13a having a relatively low density of activated trap and a second region 13b having a relatively high density of activated trap. A thickness of the second region 13b may be less than a thickness of the first region 13a. For example, the total thickness of the memory layer 13 may be about 10 nm or more and about 30 nm or less, and the thickness of the second region 13b may be about 1 nm or more and about 4 nm or less. However, it is not limited thereto.

The first region 13a is adjacent to the first electrode 11. The activated traps in the first region 13a are indicated by the circle of the comb pattern. The density of activated trap in the first region 13a may gradually increase toward a boundary with the second region 13b, but the amount of increase may be relatively small. The second region 13b is adjacent to the second electrode 12. In addition, the second region 13b may be in direct contact with the first region 13a and may be disposed between the first region 13a and the second electrode 12. The activated traps in the second region 13b are indicated by the circle of the network pattern. The density of the activated trap in the second region 13b may increase relatively significantly toward the boundary with the second electrode 12. Accordingly, the density of activated trap in the second region 13b may be higher than the density of activated trap in the first region 13a. In this case, the memory layer 13 is in a first state in which the threshold voltage is relatively low. In other words, when the memory layer 13 is in the first state, the density of activated trap in the second region 13b is higher than the density of activated trap in the first region 13a.

Referring to FIG. 5B, the energy band formed by activated traps in the first region 13a is indicated by a dotted line. The energy band formed by the activated traps may be located at an energy level slightly lower than the Fermi level Ef. In addition, referring to FIG. 5C, the energy band formed by activated traps in the second region 13b is indicated by a thick dashed line. When comparing FIG. 5B with FIG. 5C, the energy band formed by the activated traps in the second region 13b has a slightly wider energy distribution than the energy band formed by the activated traps in the first region 13a. In addition, the density of state of activated traps in the second region 13b is greater than the density of state of activated traps in the first region 13a. Therefore, the amount of activated traps in the second region 13b is greater than the amount of activated traps in the first region 13a.

Such a high density of activated trap near the second electrode 12 after first-firing may greatly affect a threshold voltage shift behavior of the memory layer 13. For example, the density of activated trap in the second region 13b may be changed relatively easily according to a polarity of a bias voltage, and accordingly, the threshold voltage of the memory layer 13 may be shifted relatively easily, which may enable a relatively easy set operation and/or a relatively easy RESET operation.

When a negative (-) bias voltage is applied to the first-fired memory layer 13, in other words, when the bias voltage is applied to the memory layer 13 in a reverse direction so that current flows from the first electrode 11 to the second electrode 12, some of the activated traps are annihilated in the second region 13b close to the second electrode 12 and are changed to de-activated traps. As a result, the density of activated traps in the memory layer 13 is reduced.

When comparing FIG. 5A with FIG. 6A, after the negative (-) bias voltage is applied to the memory layer 13, the density of activated traps in both the first region 13a and the second region 13b may be reduced. The density of the activated traps in the second region 13b may be significantly reduced compared to the first region 13a. On the other hand, a density change amount of the activated traps in the first region 13a may be less than a density change amount of the activated traps in the second region 13b. Accordingly, after the negative (-) bias voltage is applied to the memory layer 13, the density of the activated traps in the second region 13b may be less than the density of the activated traps in the first region 13a. As a result, an interface tunneling barrier (ITB) or a space charge region may be formed in the second region 13b. A length of the second region 13b may be a length Ls of the space charge region.

In addition, when comparing FIG. 5B with FIG. 6B, after the negative (-) bias voltage is applied to the memory layer 13, the density of state of activated traps in the first region 13a may be slightly reduced. On the other hand, when comparing FIG. 5C with FIG. 6C, after the negative (-) bias voltage is applied to the memory layer 13, the density of state of the activated traps in the second region 13b may be relatively significantly reduced. In addition, when comparing FIG. 6B with FIG. 6C, it may be seen that after the negative (-) bias voltage is applied to the memory layer 13, a peak of the density of state of activated traps in the second region 13b is less than a peak of the density of state of activated traps in the first region 13a.

When the amount of activated traps is reduced in the memory layer 13, especially in the second region 13b close to the second electrode 12, the percolation path may be reduced. Accordingly, a greater bias voltage may be required to form the electrical conduction path, and accordingly, the threshold voltage of the memory layer 13 may increase. At this time, the memory layer 13 may be in a second state in which the threshold voltage is relatively high. In other words, when the memory layer 13 is in the second state, the density of the activated trap in the second region 13b may be lower than the density of the activated trap in the first region 13a. In addition, the density of the activated trap in the first region 13a and the density of the activated trap in the second region 13b when the memory layer 13 is in the second state may be lower than the density of the activated trap in the first region 13a and the density of the activated trap in the second region 13b when the memory layer 13 is in first second state, respectively.

Thereafter, when a positive (+) bias voltage greater than or equal to the threshold voltage is applied to the memory layer 13, the threshold voltage of the memory layer 13 may be decreased again as the amount of activated traps in the memory layer 13 increases, especially in the second region 13b. Then, the memory layer 13 may be in the first state. As described above, in the memory device 10 according to an embodiment, the threshold voltage shift behavior may be implemented through a state change of the activated trap in the memory layer 13, especially through a large state change of the activated trap in the second region 13b of the memory layer 13 close to the second electrode 12. Meanwhile, because the density of the activated trap in the pristine state is lower than the density of the activated trap with the negative (-) bias voltage applied after first firing, the positive (+) bias voltage required for first-firing may be higher than the positive (+) bias voltage required for decreasing the threshold voltage of the memory layer 13 again after the negative (-) bias voltage is applied.

In the memory device 10 according to an embodiment, the memory layer 13 may include an amorphous chalcogenide-based material, for example, a selenium (Se)-based quinary semiconductor compound.

In the memory device 10 according to an embodiment, as described below, the memory layer 13 may include a semiconductor compound in which the length Ls of the space charge region is approximately 1 nm or more, thereby increasing a memory window of the memory device 10.

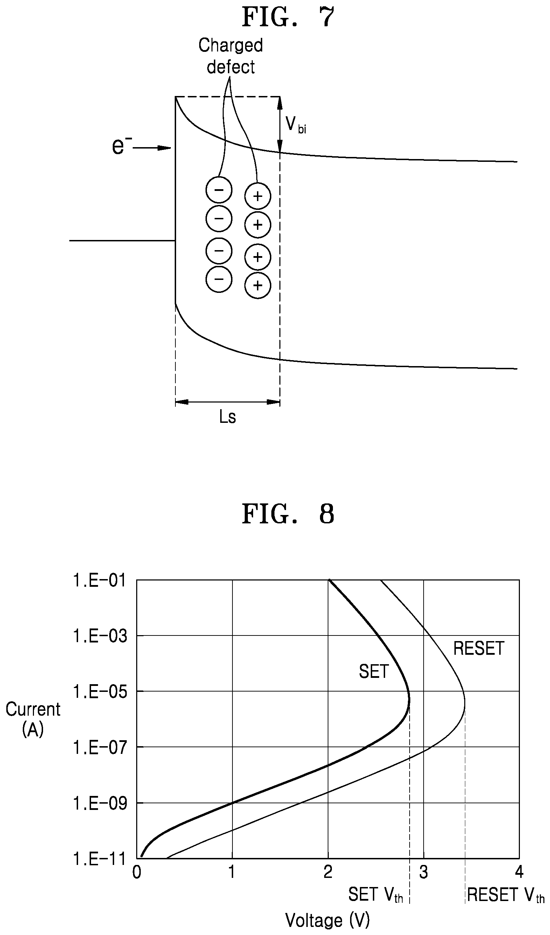

FIG. 7 schematically illustrates a band diagram of a space charge region formed by a RESET operation in the memory device 10 according to an embodiment. Referring to FIG. 7, charged defects having different polarities are accumulated near an interface of the memory layer 13 during the RESET operation, and the space charge region is formed due to band bending. The space charge region serves as an electrical barrier to prevent electron injection during a read operation. In FIG. 7, "Ls" refers to a length of the space charge region, and "$V_{bi}$" refers to a built-in potential or a potential barrier.

Ls may be calculated by the following equation.

$$L_S = \sqrt{\frac{2\varepsilon_0\varepsilon_r}{qN_t}(Vbi - V)}$$

Equation 1

Here, $\varepsilon_0$ represents a dielectric constant of vacuum, $\varepsilon_r$ represents a dielectric permittivity, Nt represents a trap density, Vbi represents the built-in potential, q represents an amount of charges, and V represents an applied voltage. When the length Ls of the space charge region is, for example, 1 nm or more, a shift characteristic of a threshold voltage for a self-selecting memory device may be secured. However, the length Ls of the space charge region is not limited thereto.

FIG. 8 illustrates a V-I curve showing that a memory window is generated in the memory device 10 according to an embodiment by simulating a result shown in FIG. 7. Referring to FIG. 8, it may be seen that the memory window is generated because a threshold voltage RESET $V_{th}$ in a reset operation is higher than the threshold voltage SET $V_{th}$ in a set operation.

The following shows the threshold voltage Vth, Vth_drift, and memory window ΔVth according to the composition of the memory material Ge-As-Se-In-O.

[Table 1]

| Number | Ge | As | Se | In | O | Vth (V) | Vth_drift (mV/dec) | ΔVth (V) |
|--------|------|------|------|-----|-----|---------|--------------------|----------|
| 1 | 22.1 | 28.6 | 46.6 | 2.7 | 0 | 3.05 | 62.5 | 1.63 |
| 2 | 21.8 | 29 | 46.5 | 2.7 | 1.5 | 3.2 | 48.29 | 1.53 |
| 3 | 22 | 28.1 | 47.2 | 2.7 | 3 | 3.3 | 52.44 | 1.61 |
| 4 | 22.6 | 27.9 | 46.8 | 2.7 | 5 | 4.15 | 59.9 | 1.49 |

In Table 1, the total content of Ge, As, Se, and In is 100 at%, and the content of oxygen (O) may represent a ratio to the total content of Ge, As, Se, and In.

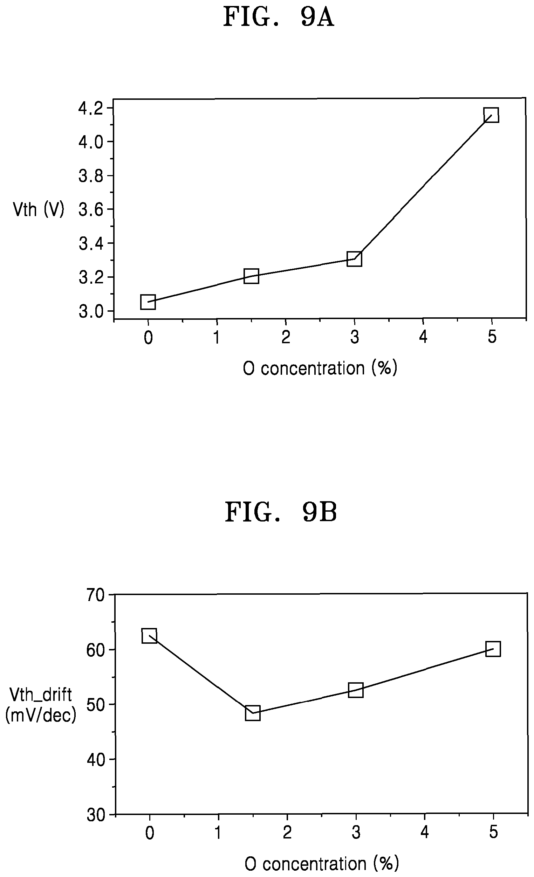

FIG. 9A illustrates the change in threshold voltage Vth according to oxygen (O) concentration in the composition of Table 1. It shows that the threshold voltage Vth increases as the oxygen concentration increases.

FIG. 9B shows the variation in Vth_drift as a function of oxygen (O) concentration. It demonstrates Vth_drift is lower when the oxygen concentration is 1.5 at%, 3 at%, and 5 at% compared to when the oxygen concentration is 0.

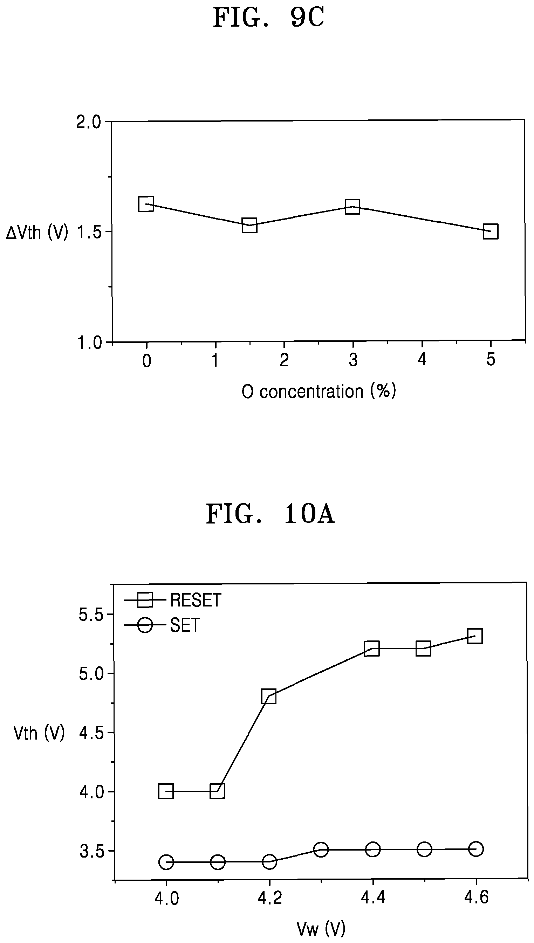

FIG. 9C shows the memory window ΔVth relative to oxygen (O) concentration. It shows that the range of change in the memory window (ΔVth) remains stable.

FIGS. 10A to 10D illustrate the change in threshold voltage Vth with respect to writing voltage Vw when the oxygen (O) concentration is 0, 1.5 at%, 3 at%, and 5 at%, respectively, in the composition of Table 1, thereby showing the memory window.

In FIG. 10A, the square dots represent the RESET threshold voltage, and the circular dots represent the SET threshold voltage. Referring to FIG. 10A, a memory window is created in which the RESET threshold voltage is higher than the SET threshold voltage, and the memory window is approximately 1.63 V when the oxygen concentration is 0.

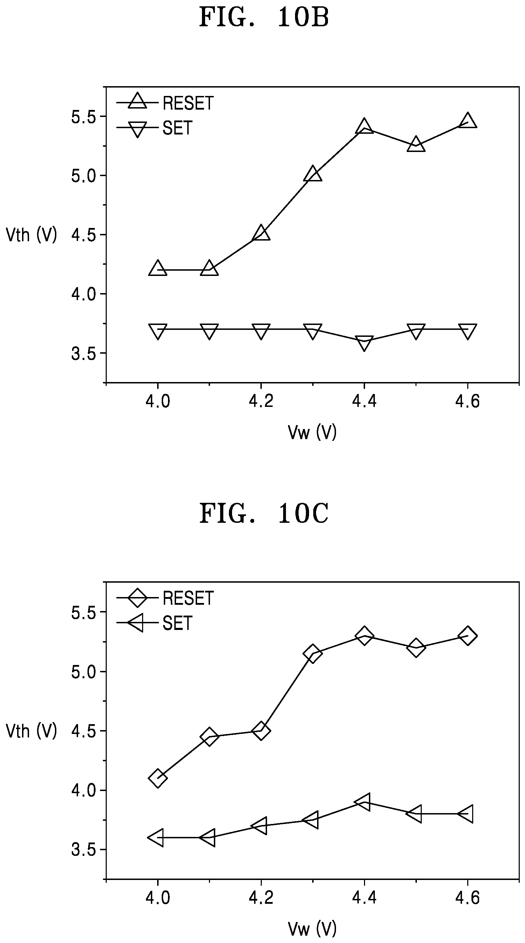

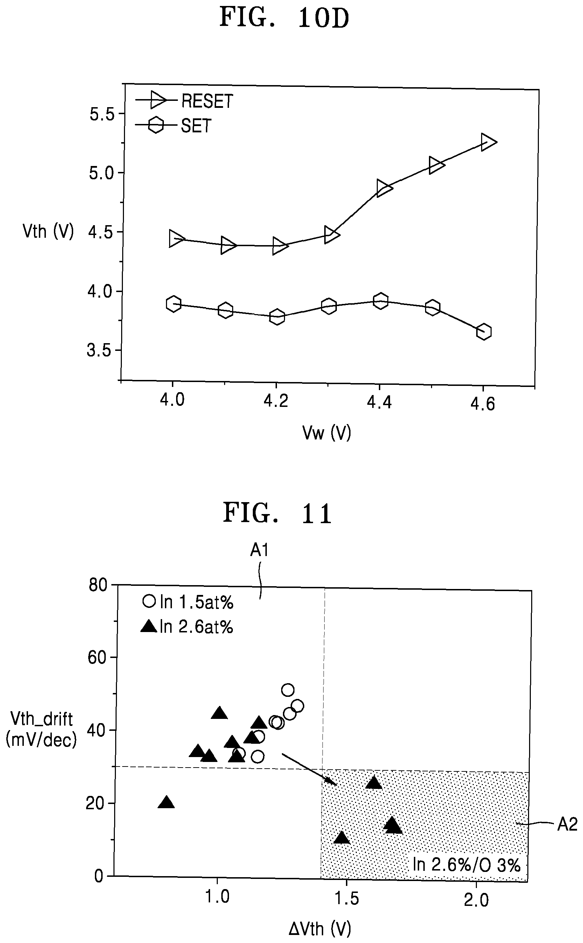

Referring to FIG. 10B, the memory window is about 1.53 V when the oxygen concentration is 1.5 at%. Referring to FIG. 10C, the memory window is about 1.70 V when the oxygen concentration is 3 at%. Referring to FIG. 10D, the memory window is about 1.49 V when the oxygen concentration is 5 at%.

As previously described, the comparative example without oxygen (O) has a relatively favorable memory window ΔVth of 1.63, but a relatively high Vth_drift of 62.5 (mV/dec).

In contrast, in examples with 1.5 at%, 3 at%, and 5 at% oxygen (O), each example demonstrates a favorable memory window ΔVth of over 1.45V, and Vth_drift values below 60 (mV/dec). As described above, the memory device 10 according to an embodiment, which includes Ge-As-Se-In-O, may secure both memory window and Vth_drift characteristics.

For example, the content of In included in the memory layer 13 may be greater than about 0 at% or 7 at% or less. The content of In included in the memory layer 13 may be about 0.1 at% to about 5 at%, about 1 at% to about 4 at%, about 2 at% to about 3 at%, or about 2.5 at% to about 2.8 at%. The content of Ge included in the memory layer 13 may be about 10 at% or more and about 40 at% or less. Alternatively, the Ge content may be about 13 at% or more and about 36 at% or less. Alternatively, the content of Ge may be about 15 at% or more and about 33 at% or less, about 15 at% to about 30 at%, about 15 at% to about 27 at%, about 15 at% to about 25 at%, about 15.5 at% to about 24 at%, or about 15.5 at% to about 23 at%. The content of Se included in the memory layer 13 may be about 30 at% or more and about 70 at% or less. Alternatively, the content of Se may be about 33 at% or more and about 67 at% or less. Alternatively, the content of Se may be about 37 at% or more and about 62 at% or less, about 40 at% to about 61 at%, about 45 at% to about 60 at%, or about 46.5 at% to about 60 at%. The content of As included in the memory layer 13 may be about 15 at% or more and about 40 at% or less. Alternatively, the content of As may be about 18 at% or more and about 37 at% or less. Alternatively, the content of As may be about 21 at% or more and about 34 at% or less, about 21 at% to about 32 at%, about 21.5 at% to about 30 at%, or about 21.5 at% to about 29 at%. The content of O included in the memory layer 13 may be greater than about 1 at% and less than or equal to about 10 at%. Alternatively, the O content may be greater than about 1 at% and less than or equal to about 5 at%, or about 1.5 at% to about 5 at%. When oxygen (O) is included in excess of 10 at%, oxidation of the memory layer 13 may progress, which may adversely affect Vth_drift and the memory window.

FIG. 11 shows the distribution of memory window (ΔVth) and Vth_drift according to the Ge-As-Se-In-O composition. Region A1 represents an area with high Vth_drift and a small memory window. Comparative examples having no oxygen and compositions in the ranges of 10 < Ge < 35 (at%), 20 < As < 35 (at%), and 40 < Se < 60 (at%) are distributed in Region A1. Circular dots represent an example where In has a content of 1.5 at%, and the triangular dots represent an example where In has a content of 2.6 at%.

The following table shows the composition, Vth, Ioff, Vth_drift, and ΔVth of two comparative examples in Region A1. Ioff may represent a leakage current that flows when no voltage is applied.

[Table 2]

| Number | Ge | As | Se | In | O | Vth (V) | Ioff (A) | Vth_drift (mV/dec) | ΔVth (V) |
|---|---|---|---|---|---|---|---|---|---|
| 1 | 17.3 | 28.7 | 51.4 | 2.6 | 0 | 3.0 | 8.0E-10 | 42.30 | 1.15 |
| 2 | 22.8 | 22.1 | 52.5 | 2.6 | 0 | 3.175 | 2.4E-9 | 44.8 | 1.00 |

Region A2 in FIG. 11 is an area with a low Vth_drift and a large memory window. Embodiments with oxygen are distributed in the Region A2. The following table shows the composition and Vth, Ioff, Vth_drift, and ΔVth of some embodiments in Region A2.

[Table 3]

| Number | Ge | As | Se | In | O | Vth (V) | Ioff (A) | Vth_drift (mV/dec) | ΔVth (V) |
|---|---|---|---|---|---|---|---|---|---|
| 1 | 15.8 | 21.9 | 59.7 | 2.6 | 3 | 3.35 | 8.21E-10 | 14.06 | 1.68 |
| 2 | 17.1 | 28.8 | 51.4 | 2.7 | 3 | 3.3 | 6.88E-10 | 15.13 | 1.67 |
| 3 | 18.4 | 24.5 | 54.5 | 2.6 | 3 | 3.35 | 5.25E-10 | 11.24 | 1.48 |
| 4 | 22.2 | 21.9 | 53.4 | 2.6 | 3 | 3.60 | 3.93E-10 | 26.39 | 1.60 |

In Table 3, the total content of Ge, As, Se, and In is 100 at%, and the content of oxygen (O) may represent a ratio to the total content of Ge, As, Se, and In.

As described above, the memory device 10 according to an embodiment, containing oxygen, demonstrates a relatively larger memory window (ΔVth) and a relatively smaller Vth_drift compared to cases without oxygen.

The memory device 10 according to an embodiment may have low leakage current, a large memory window, and low Vth_drift. Therefore, the memory device 10 may be usefully applied as a self-selecting memory element in a cross-point array. In cross-point arrays, self-selecting memory requires a high memory window and low Vth_drift. Self-selecting memory materials include amorphous materials, and the threshold voltage Vth of the amorphous material exhibits a drift phenomenon in which it gradually increases over time. Vth_drift represents the amount of change in threshold voltage over a certain period of time. The smaller the Vth_drift, the higher the reliability of the memory device. Therefore, OTS materials may include materials exhibiting small Vth_drift. In an embodiment, Se and In form a stable bond, exhibiting excellent Vth_drift characteristics. Additionally, oxygen in an embodiment may help reduce leakage current and contribute to maintaining or enhancing the memory window. As a result, the memory device according to an embodiment may overcome the trade-off relationship between the memory window and Vth_drift, satisfying both characteristics.

Meanwhile, in neuromorphic computing, a memristor that has both memory and resistor functions and an OTS-based selector may be applied. Memory materials according to an embodiment may be applied to the OTS-based selector. A memristor is a memory device that remembers the amount of current that has passed through it as resistance. A memristor may change its resistance through voltages of various directions and magnitudes, and may significantly reduce energy consumption when used as computer system memory. OTS selector materials may be applied to resistance-change-based memristor technologies such as ReRAM, MRAM, and PRAM.

As described above, the memory device 10 according to an embodiment may perform both a memory function and a selector function with only a single material by using a phenomenon of a change in the density of an activated trap depending on a polarity and an intensity of a bias voltage. Therefore, a unit memory cell may be implemented with only one memory device 10 without a separate selector. The memory device 10 according to an embodiment may perform both the memory function and the selector function with one memory layer 13, and thus, an aspect ratio of the memory device 10 may be reduced, and the memory device 10 may be manufactured through a relatively simple process.

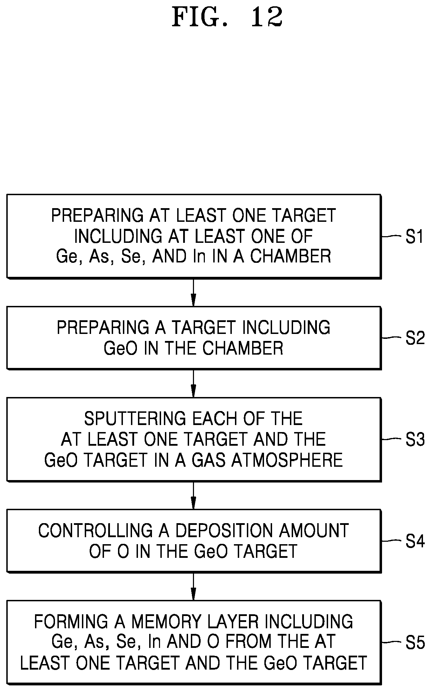

FIG. 12 is a diagram illustrating a method of manufacturing a memory device according to an embodiment.

Referring to FIG. 12, a method of manufacturing a memory device may include preparing at least one target including at least one of Ge, As, Se, and In in a chamber (S1). Additionally, the method of manufacturing the memory device may include preparing a target including GeO in the chamber (S2). In an embodiment, a co-sputtering method involving multiple targets may be used. Then at least one target and the GeO target prepared may be sputtered respectively in a gas atmosphere (S3). The deposition amount of O in the GeO target may be controlled (S4). The O content in the GeO target may be greater than about 0 at% and less than or equal to about 10 at%. Elements separated from the at least one target and the GeO target may be deposited on the substrate or the first electrode 11 of FIG. 1. Through this process, a memory layer including Ge, As, Se, In, and O may be formed from the at least one target and the GeO target (S5).

In the memory layer manufactured as described above, the content of In may be greater than about 0 at% and less than or equal to about 7 at%. The content of O in the memory layer may be greater than about 1 at% and less than or equal to about 10 at%. Alternatively, the content of O in the memory layer may be greater than about 1 at% and less than or equal to about 5 at%. The contents of Ge, As, and Se are the same as described with reference to FIG. 1.

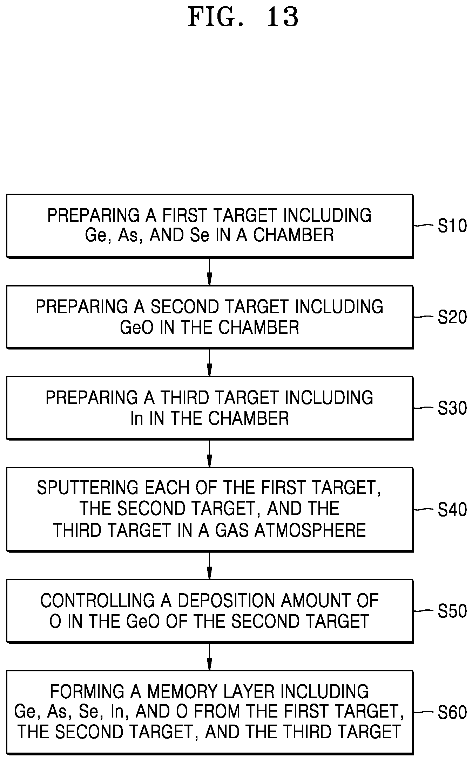

FIG. 13 illustrates an example of the co-sputtering method described with reference to FIG. 12. Referring to FIG. 13, a method of manufacturing a memory device may include preparing a first target including Ge, As, and Se in a chamber (S10). Then, a second target including GeO may be prepared in the chamber (S20), and a third target including In may be prepared in the chamber (S30). The first, second, and third targets may be prepared in the same chamber, and the first, second, and third targets may be sputtered respectively in a gas atmosphere (S40). The deposition amount of O in GeO of the second target may be controlled (S50). In an embodiment, the deposition amount of O may be precisely controlled to a very small amount. The gas that may be used is, for example, Ar gas. Elements separated from the first, second, and third targets may be deposited on the substrate or the first electrode 11 of Fig. 1. Through this process, a memory layer including Ge, As, Se, In, and O may be formed from the first, second, and third targets (S60). The content of O in the GeO of the second target may be greater than about 1 at% and less than or equal to about 10 at%.

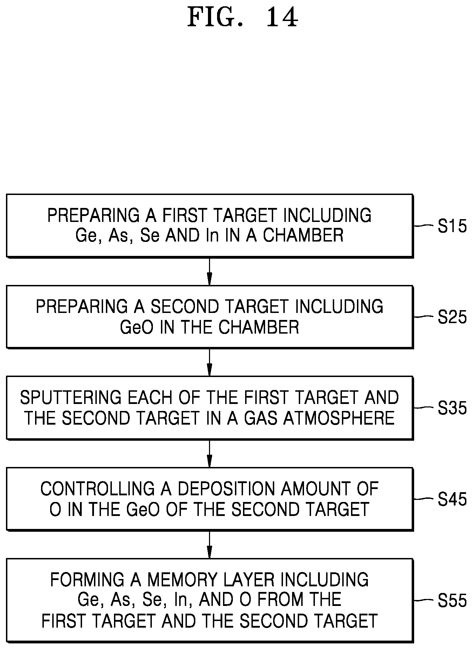

FIG. 14 illustrates another example of the co-sputtering method described with reference to FIG. 12. Referring to FIG. 14, a method of manufacturing a memory device may include preparing a first target including Ge, As, Se, and In in a chamber (S15). Then, a second target including GeO may be prepared in the chamber (S25). The first and the second targets may be prepared in the same chamber, and be sputtered respectively in a gas atmosphere (S35). The deposition amount of O from GeO in the second target may be controlled (S45). The content of O in the second target may be greater than about 1 at% and less than or equal to about 10 at%. A memory layer including Ge, As, Se, In, and O may be formed from the first and second targets (S55).

As described above, a method of manufacturing a memory device according to an embodiment may form a memory layer including Ge, As, Se, In, and O using a plurality of targets.

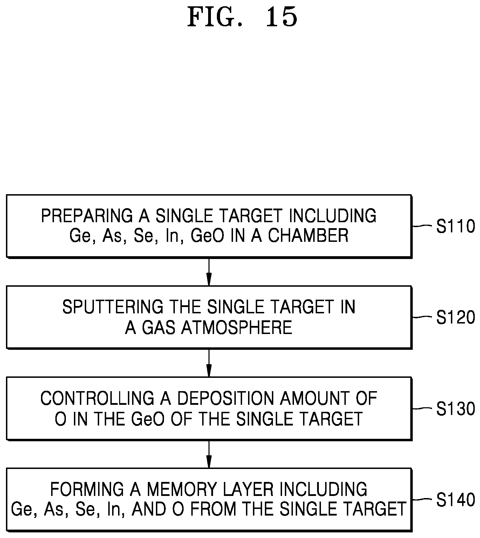

FIG. 15 is a diagram illustrating a method of manufacturing a memory device according to another embodiment.

Referring to Fig. 15, a single target including Ge, As, Se, In, and GeO may be prepared in a chamber (S110). Ge and GeO may exist separately within the single target. The single target may then be sputtered in a gas atmosphere (S120). The gas may include, for example, Ar gas. The deposition amount of O from GeO in the single target may be controlled (S130). Elements separated from the single target may be deposited on the substrate or the first electrode 11 of Fig. 1. Through this process, a memory layer including Ge, As, Se, In, and O may be formed from the single target (S140). The content of O in the single target may be greater than about 1 at% and less than or equal to about 10 at%. The content of In in the memory layer may be greater than about 0 at% and less than or equal to about 7 at%. Additionally, the content of O in the memory layer may be greater than about 1 at% and less than about 10 at%. Alternatively, the content of O in the memory layer may be greater than about 1 at% and less than or equal to about 5 at%. The contents of Ge, As, and Se are as described with reference to FIG. 1. When a single target is used as in an embodiment, the sputtering process may be simplified.

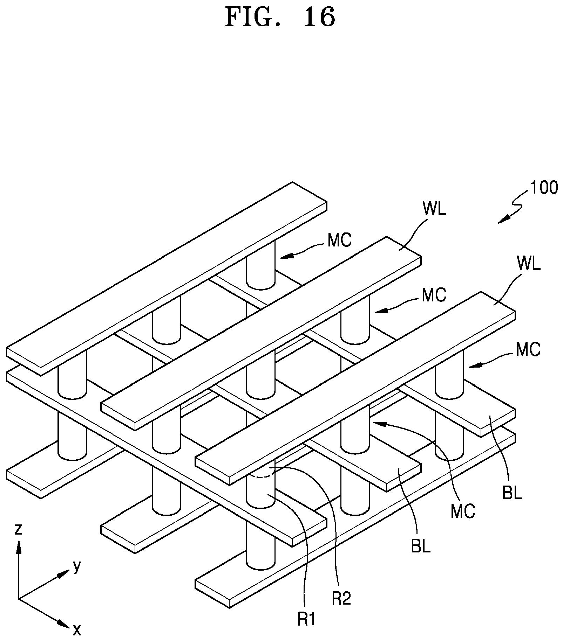

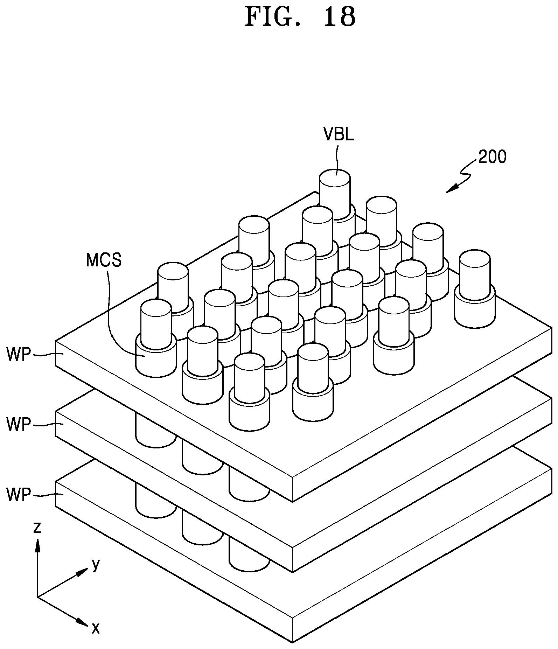

A method for manufacturing a memory device according to an example embodiment may further include a step of patterning the memory layer manufactured as described above. In addition, electrodes may be connected to both ends of the patterned memory layer. The electrodes may include a first electrode 11 provided on a lower portion of the memory layer 13 and a second electrode 12 provided on an upper portion of the memory layer 13, as illustrated in FIG. 1. Alternatively, the electrodes may include a word line WL and a bit line BL, as illustrated in FIG. 16. Alternatively, the electrodes may include a word plane WP and a vertical bit line VBL, as illustrated in FIG. 18.

FIG. 16 is a perspective diagram schematically illustrating a structure of the memory device 100 according to an embodiment. Referring to FIG. 16, the memory device 100 may have a three-dimensional cross point structure. For example, the memory device 100 may include a plurality of bit lines BL extending in a first direction (that is, an x-axis direction), a plurality of word lines WL extending in a second direction (that is, a y-axis direction) crossing the first direction, and a plurality of memory cells MC provided at points at which the plurality of bit lines BL and the plurality of word lines WL cross each other. Each of the plurality of memory cells MC may have a bar shape and correspond to the memory layer 13 of the memory device 10 shown in FIG. 1. Therefore, each of the plurality of memory cells MC may include the same material as the memory layer 13 of the memory device 10 shown in FIG. 1, and may have the same characteristics. In addition, each of the plurality of bit lines BL may correspond to the first electrode 11 of the memory device 10 shown in FIG. 1, and each of the plurality of word lines WL may correspond to the second electrode 12 of the memory device 10 shown in FIG. 1. However, the first electrode 11 and the second electrode 12 may be separately provided in addition to the bit line BL and the word line WL.

In such a structure, the memory cell MC may be driven by a potential difference between the word line WL and the bit line BL connected to both ends of each of the plurality of memory cells MC. For example, in a first state with a relatively low first threshold voltage, the memory cell MC may change to a second state with a relatively high second threshold voltage when a potential difference between the word line WL and the bit line BL is a (-) bias voltage, e.g., -4 V or less. In addition, in a second state with a relatively high second threshold voltage, the memory cell MC may change to a first state with the relatively low first threshold voltage when a potential difference between the word line WL and the bit line BL is greater than or equal to the second threshold voltage, e.g., +4 V or more. When data recorded in the memory cell MC is read, the potential difference between the word line WL and the bit line BL may be between the first threshold voltage and the second threshold voltage, for example, about +3 V to about +3.5 V. Furthermore, a driving speed of the memory device 100 according to an embodiment may be, for example, about 0.7 nsec or more and about 20 nsec or less, about 0.7 nsec or more and about 10 nsec or less, or about 0.7 nsec or more and about 5 nsec or less. However, the disclosure is not limited thereto.

In addition, as described with reference to FIGS. 5A, 6A, and 16, each of the plurality of memory cells MC may have a first region R1 in contact with the corresponding bit line among the plurality of bit lines BL and the second region R2 in contact with a corresponding word line among the plurality of word lines WL. When the memory cell MC is in the first state, the density of activated trap in the second region R2 may be higher than the density of activated trap in the first region R1. On the other hand, when the memory cell MC is in the second state, the density of the activated trap in the second region R2 may be lower than the density of the activated trap in the first region R1.

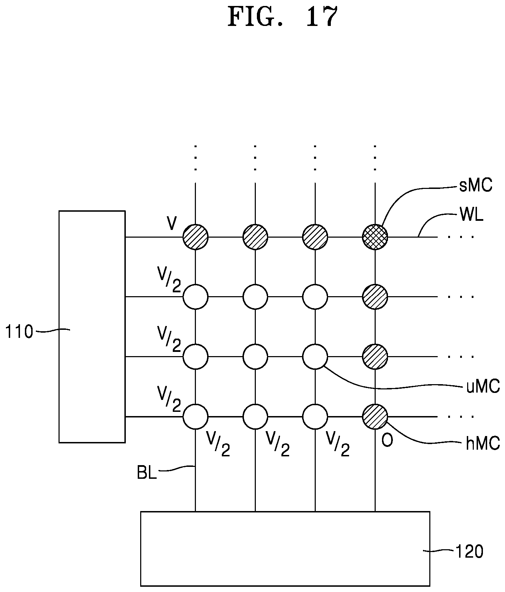

FIG. 17 is a plan view illustrating an operation in which the memory device 100 shown in FIG. 16 selects a specific memory cell. Referring to FIG. 17, the memory device 100 may further include a row decoder 110 configured to selectively supply a voltage to the plurality of word lines WL and a column decoder 120 configured to selectively supply a voltage to the plurality of bit lines BL. When a voltage of V is applied to a selected memory cell sMC selected from the plurality of memory cells MC, the row decoder 110 may provide the voltage of V to a word line WL connected to the selected memory cell sMC and a voltage of V/2 to the other word lines WL. At this time, the column decoder 120 may provide a voltage of 0 V to a bit line BL connected to the selected memory cell sMC and a voltage of V/2 to the other bit lines BL.

Then, a potential difference between the word line WL and the bit line BL connected to the selected memory cell sMC becomes V. However, a potential difference between the word lines WL to which the voltage of V/2 is applied and the bit lines BL to which the voltage of V/2 is applied becomes 0 V. Therefore, no voltage is applied to unselected memory cells uMC disposed between the word lines WL and the bit lines BL that are not connected to the selected memory cell sMC. Meanwhile, a voltage of V/2 may be applied between both ends of each of half-selected memory cells hMC that are connected to the same word line WL as the selected memory cell sMC or the same bit line BL as the selected memory cell sMC. The memory cell MC according to an embodiment is a self-selecting memory device having the threshold voltage described above. Even when the voltage of V/2 is applied to the half-selected memory cells hMC adjacent to the selected memory cell sMC, the half-selected memory cell hMC is not turned on, and thus, substantially no sneak current may occur.

FIG. 18 is a perspective view schematically illustrating a memory device 200 according to another embodiment. Referring to FIG. 18, the memory device 200 may include a plurality of word planes WP extending in a plane having a first direction (x-axis direction) and a second direction (y-axis direction), and disposed to be spaced apart from each other in a third direction (z-axis direction) crossing the first direction (x-axis direction) and the second direction (y-axis direction); a plurality of vertical bit lines VBL extending in the third direction (z-axis direction) and two-dimensionally aligned in the first direction (x-axis direction) and the second direction (y-axis direction); and a plurality of memory cell strings MCS surrounding surfaces of the plurality of vertical bit lines VBL and extending in the third direction (z-axis direction). Like the plurality of vertical bit lines VBL, the plurality of memory cell strings MCS may be two-dimensionally aligned in the first direction (x-axis direction) and the second direction (y-axis direction). Each of the plurality of memory cell strings MCS and each of the plurality of vertical bit lines VBL may be disposed to penetrate the plurality of word planes WP in the third direction (z-axis direction). Each of the plurality of memory cell strings MCS extends in a vertical direction, that is, in the z-axis direction, and thus, the memory device 200 shown in FIG. 18 may be referred to as a vertical memory device, and may have further enhanced memory capacity. Each of the plurality of memory cell strings MCS may include the same material as the memory layer 13 of the memory device 10 shown in FIG. 1. In addition, each of the plurality of vertical bit lines VBL may correspond to the first electrode 11 of the memory device 10 shown in FIG. 1, and each of the plurality of word planes WP may correspond to the second electrode 12 of the memory device 10 shown in FIG. 1. The memory cell strings MCS may include a memory layer (not shown) have a same material as the memory layer 13 of the memory device 10 shown in FIG. 1.

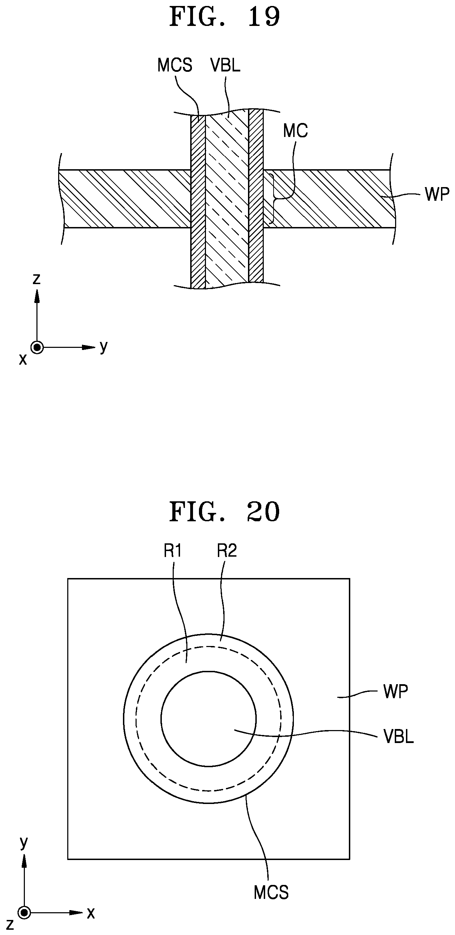

FIG. 19 is a vertical cross-sectional view schematically illustrating a structure of one memory cell in the memory device 200 shown in FIG. 18. Referring to FIG. 19, a region surrounded by one word plane WP in each of the plurality of memory cell strings MCS extending in the third direction (z-axis direction) may form one memory cell MC. Therefore, one memory cell string MCS may include the plurality of memory cells MC arranged to be spaced apart from each other in the third direction (z-axis direction). Each of the memory cells MC may correspond to the memory layer 13 of the memory device 10 shown in FIG. 1, and may have the same characteristics as the memory layer 13 of the memory device 10 shown in FIG. 1.

FIG. 20 is a horizontal cross-sectional view schematically illustrating a configuration of one memory cell in the memory device 200 shown in FIG. 19. Referring to FIG. 20, one memory cell MC may have a ring shape. In addition, the memory cell MC may include the first region R1 of a ring shape in contact with and surrounding the corresponding vertical bit line among the plurality of vertical bit lines VBL and the second region R2 of a ring shape surrounding the first region R1. The second region R2 may be in contact with and surrounded by a corresponding word plane among the plurality of word planes WP. The first region R1 and the second region R2 may be aligned concentrically. The first region R1 may correspond to the first region 13a illustrated in FIGS. 5A and 6A, and the second region R2 may correspond to the second region 13b illustrated in FIGS. 5A and 6A. Therefore, when the memory cell MC is in a first state having a relatively low threshold voltage, the density of activated trap in the second region R2 may be higher than the density of activated trap in the first region R1. When the memory cell MC is in a second state having a relatively high threshold voltage, the density of the activated trap in the second region R2 may be lower than the density of the activated trap in the first region R1. Also, a width of the second region R2 in a radial direction may be less than a width of the first region R1 in the radial direction.

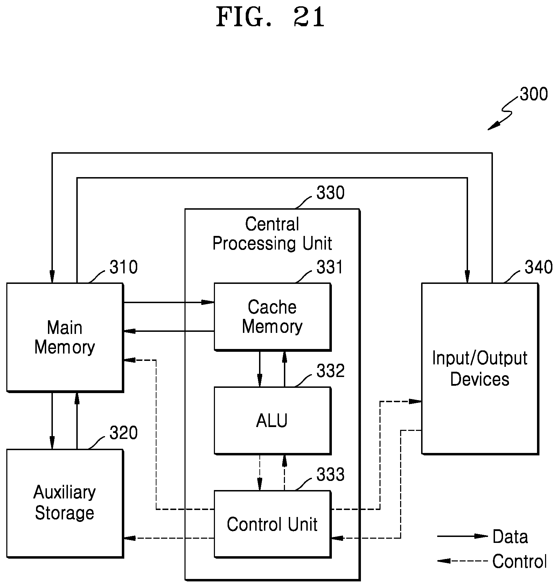

The memory device 100, 200 described above may be used for data storage in various electronic devices. FIG. 21 is a conceptual view schematically illustrating a device architecture applicable to an electronic device according to some embodiments. Referring to FIG. 21, the electronic device 300 may include a main memory 310, an auxiliary storage 320, a central processing unit (CPU) 330, and input/output devices 340 (e.g., keyboard, mouse, display). The CPU 330 may include a cache memory 331, an arithmetic logic unit (ALU) 332, and a control unit 333. The cache memory 331 may include (and/or be composed of) static random access memory (SRAM). The main memory 310 may include a dynamic random-access memory (DRAM) device, and the auxiliary storage 320 may include the memory devices 100 and 200 according to an embodiment. Alternatively, all of the cache memory 331, the main memory 310, and the auxiliary storage 320 may include the memory devices 100 and 200 according to an embodiment. In some cases, the electronic device 300 may be implemented in the form in which computing unit devices and memory unit devices are adjacent to each other on one chip without any distinction between sub-units described above.

Some of the elements and/or function blocks disclosed above may be implemented as a processing circuitry such as hardware including a logic circuit, a hardware/software combination such as processor execution software, or a combination thereof. For example, the processing circuitry may include a CPU, an arithmetic logic unit (ALU), a digital signal processor, a microcomputer, a field-programmable gate array (FPGA), an SoC, a programmable logic unit, a microprocessor, an application-specific integrated circuit (ASIC), or the like. The processing circuitry may include electronic components such as at least one of a transistor, a resistor, a capacitor, etc. The processing circuitry may include electronic components such as at least one logic gate such as an AND gate, an OR gate, a NAND gate, a NOR gate, etc.

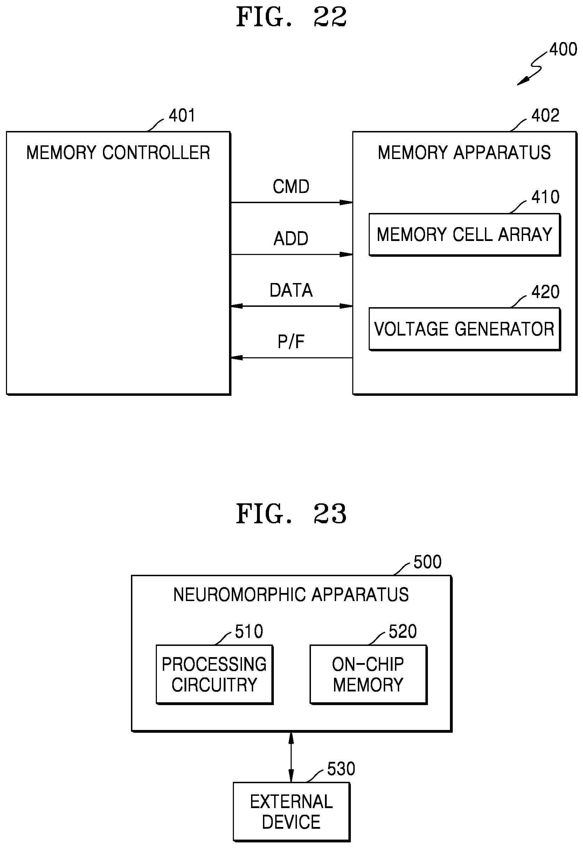

FIG. 22 is a block diagram illustrating a memory system 400 according to an embodiment.

Referring to FIG. 22, the memory system 400 may include a memory controller 401 and a memory apparatus 402, The memory controller 401 performs a control operation on the memory apparatus 402. For example, the memory controller 401 provides, to the memory apparatus 402, an address ADD and a command CMD for performing programming (or write), read, and/or erase operations on the memory apparatus 402. Additionally, data for programming operations and read data may be transmitted between the memory controller 401 and the memory apparatus 402.

The memory apparatus 402 may include a memory cell array 410 and a voltage generator 420. The memory cell array 410 may include a plurality of memory cells, and may include a memory device 100, 200 according to the embodiment described above. The plurality of memory cells may include a memory device 10.

The memory controller 401 may include a processing circuitry such as hardware with logic circuits; a hardware/software combination such as processor execution software; or a combination thereof. For example, the processing circuitry may include a CPU, an ALU, a digital signal processor, a microcomputer, a FPGA, a SoC, a programmable logic unit, a microprocessor, an ASIC, etc. but is not limited thereto. The memory controller 401 may operate in response to a request from a host (not shown), and may be configured to be converted into a special purpose controller by accessing to the memory apparatus 402 and controlling a control operation (e.g., the write/read operation) discussed above. The memory controller 401 may generate the address ADD and the command CMD for performing the programming/read/erase operation on the memory cell array 410. In addition, in response to a command from the memory controller 401, the voltage generator 420 (e.g. a power circuit) may generate a voltage control signal for controlling a voltage level of a word line to program data in the memory cell array 410 or read data from the memory cell array 410.

In addition, the memory controller 401 may perform a determination operation on data read from the memory apparatus 402. For example, the number of on-cells and/or the number of off-cells may be determined based on the data read from the memory apparatus 402. The memory apparatus 402 may provide pass/fail signals P/F to the memory controller 401 according to a result of reading the data. The memory controller 401 may control the write and read operations of the memory cell array 410 with reference to the pass/fail signals P/F.

FIG. 23 is a block diagram illustrating a neuromorphic apparatus 500 and an external device 530 connected thereto, according to an embodiment.

Referring to FIG. 23, the neuromorphic apparatus 500 may include a processing circuitry 510 and/or an on-chip memory 520. The on-chip memory 520 may include the memory devices 100 and 200 of the embodiments described above.

In some embodiments, the processing circuitry 510 may be configured to control a function for driving the neuromorphic apparatus 500. For example, the processing circuitry 510 may be configured to control the neuromorphic apparatus 500 by executing a program stored in the on-chip memory 520. In some embodiments, the processing circuitry 510 may include hardware such as a logic circuit, a hardware/software combination such as a processor configured to execute software, or a combination thereof. For example, the processing circuitry 510 may include a CPU, a graphics processing unit (GPU), an application processor (AP) included in the neuromorphic apparatus 500, an ALU, a digital signal processor, a microcomputer, a FPGA, a SoC, a programmable logic unit, a microprocessor, an ASIC, etc. but is not limited thereto. In some embodiments, the processing circuitry 510 may read/write various data with respect to the external device 530, and/or may be configured to execute the neuromorphic apparatus 500 by using the read/written data. In some embodiments, the external device 530 may include an external memory and/or a sensor array having an image sensor (e.g., a complementary metal-oxide-semiconductor (CMOS) image sensor circuit).

In some embodiments, the neuromorphic apparatus 500 may be applied to a machine learning system. The machine learning system may use various artificial neural network organizing and processing models such as a convolutional neural network (CNN), a deconvolutional neural network, a recurrent neural network (RNN) including a long short-term memory (LSTM) unit and/or a gated recurrent unit (GRU), a stacked neural network (SNN), a state-space dynamic neural network (SSDNN), a deep belief network (DBN), a generative adversarial network (GAN), and/or a restricted Boltzmann machine (RBM).

Alternatively, or in addition, the machine learning system may include other forms of machine learning models, for example, linear and/or logistic regression, statistical clustering, Bayesian classification, decision tree, dimensionality reduction such as principal component analysis, an expert system, and/or a combination thereof including ensembles such as random forests. These machine learning models may be used to provide various services and/or applications. For example, an image classification service, a user authentication service based on biometrics or biometric data, an advanced driver assistance system (ADAS) service, a voice assistant service, or an automatic speech recognition (ASR) service may be executed by an electronic device.

The memory device according to an embodiment may have a simple structure and simultaneously implement a memory function and a selector function with a single device, and thus, the memory device may be applied to a cross-point memory device, and also to a vertical memory device capable of significantly increasing memory capacity. When applied to the vertical memory device, the structure is simple, and thus, a hole diameter may be reduced, thereby increasing memory density. In addition, the memory device according to an embodiment has a low threshold voltage and low power consumption, and thus, may be applied not only to a cross-point memory device but also to an embedded non-volatile memory device.

The embodiments described above are only non-limiting examples, and those skilled in the art may make various modifications and equivalent other embodiments based on the described embodiments. Therefore, the true technical protection scope according to embodiments should be determined by the technical ideas described in the following claims.

The self-selecting memory materials according to an embodiment include oxygen and chalcogenide-based material, which have both ovonic threshold switching characteristics and memory characteristics in which the threshold voltage changes depending on a polarity and an intensity of an applied voltage. Therefore, a unit memory cell may be implemented with just one memory, without a separate selector. The self-selecting memory materials according to an embodiment, including Ge, As, Se, In, and O, may improve both memory window and Vth_drift characteristics of memory devices.

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU) , an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

**Claims**

1. A memory device comprising:

   a plurality of bit lines extending in a first direction;
   a plurality of word lines extending in a second direction, wherein the second direction crosses the first direction; and
   a memory layer at points where the plurality of bit lines and the plurality of word lines cross each other, wherein the memory layer has a characteristic in which a threshold voltage changes depending on a polarity and an intensity of an applied voltage,
   wherein the memory layer includes Ge, As, Se, In, and O, and
   a content of In in the memory layer is greater than 0 at% and less than or equal to 7 at%.

2. The memory device of claim 1,
   wherein a content of O in the memory layer is greater than 1 at% and less than or equal to 10 at%.

3. The memory device of claim 2, wherein

   a content of Ge in the memory layer is 10 at% or more and 40 at% or less,
   a content of Se in the memory layer is 30 at% or more and 70 at% or less, and
   a content of As in the memory layer is 15 at% or more and 40 at% or less,
   and optionally wherein the memory layer further includes at least one of S, Sb, Al, and Ga in an amount of 10 at% or less.

4. The memory device of any preceding claim, wherein

   the memory layer has either a first state having a first threshold voltage or a second state having a second threshold voltage, and
   the second threshold voltage is higher than the first threshold voltage.

5. A memory device comprising:

   a plurality of word planes spaced apart from each other in a third direction, the third direction being perpendicular to a plane including a first direction and a second direction crossing each other;
   a plurality of vertical bit lines penetrating the plurality of word planes and extending in the third direction; and
   a memory cell string surrounding the plurality of vertical bit lines and extending in the third direction, wherein the memory cell string has a characteristic in which a threshold voltage changes depending on a polarity and an intensity of an applied voltage,
   wherein the memory cell string includes Ge, As, Se, In, and O, and
   a content of In in the memory cell string is greater than 0 at% and less than or equal to 7 at%.

6. The memory device of claim 6,
   wherein a content of O in the memory cell string is greater than 1 at% and less than or equal to 10 at%.

7. The memory device of claim 7, wherein

   a content of Ge in the memory cell string is 10 at% or more and 40 at% or less,
   a content of Se in the memory cell string is 30 at% or more and 70 at% or less, and
   a content of As in the memory cell string is 15 at% or more and 40 at% or less,
   and optionally wherein the memory cell string further includes at least one of S, Sb, Al, and Ga in an amount of 10 at% or less.

8. The memory device of any of claims 5 to 7, wherein

   the memory cell string has either a first state having a first threshold voltage or a second state having a second threshold voltage, and
   the second threshold voltage is higher than the first threshold voltage.

9. An electronic device comprising:
   a memory device according to any preceding claim.

10. A method of manufacturing a memory device, the method comprising:

    preparing at least one target including at least one of Ge, As, Se, and In in a chamber;
    preparing a target including GeO in the chamber;
    sputtering each of the at least one target and the target including GeO in a gas atmosphere;
    controlling a deposition amount of O in the target including GeO; and
    forming a memory layer including Ge, As, Se, In, and O from the at least one target and the target including GeO,
    wherein a content of In in the memory layer is greater than 0 at% and less than or equal to 7 at%.

11. The method of claim 10,
    wherein the preparing of the at least one target comprises preparing a first target including Ge, As, and Se and preparing a second target including In.

12. The method of claim 11,
    wherein the preparing of the at least one target comprises preparing a target including Ge, As, Se, and In.

13. The method of claim 11 or 12,
    wherein a content of O in the memory layer is greater than 1 at% and less than or equal to 10 at%.

14. The method of claim 13,

    wherein a content of Ge in the memory layer is 10 at% or more and 40 at% or less,
    a content of Se is 30 at% or more and 70 at% or less, and
    a content of As is 15 at% or more and 40 at% or less,
    and optionally wherein the memory layer further includes at least one of S, Sb, Al, and Ga in an amount of 10 at% or less.

15. The method of any of claims 10 to 14, further comprising:

    pattering the memory layer to provide a patterned memory layer; and
    connecting an electrode to both ends of the patterned memory layer.

FIG. 1

# FIG. 2

FIG. 3A

FIG. 3B

# FIG. 4A

# FIG. 4B

# FIG. 5A

# FIG. 5B

# FIG. 5C

CB

Ef

VB

# FIG. 6A

11    13a      13b    12    10

(+)    (−)

13    $L_s$

FIG. 6B

FIG. 6C

# FIG. 7

Charged
defect

$V_{bi}$

$e^-$ →

$L_s$

# FIG. 8

Current
(A)

1.E-01

1.E-03

RESET

SET

1.E-05

1.E-07

1.E-09

1.E-11

0          1          2          3          4

SET $V_{th}$          RESET $V_{th}$

Voltage (V)

# FIG. 9A

# FIG. 9B

# FIG. 9C

# FIG. 10A

# FIG. 10B

# FIG. 10C

# FIG. 10D

# FIG. 11

# FIG. 12

PREPARING AT LEAST ONE TARGET
INCLUDING AT LEAST ONE OF
Ge, As, Se, AND In IN A CHAMBER — S1

PREPARING A TARGET INCLUDING
GeO IN THE CHAMBER — S2

SPUTTERING EACH OF THE
AT LEAST ONE TARGET AND THE
GeO TARGET IN A GAS ATMOSPHERE — S3

CONTROLLING A DEPOSITION AMOUNT
OF O IN THE GeO TARGET — S4

FORMING A MEMORY LAYER INCLUDING
Ge, As, Se, In AND O FROM THE AT
LEAST ONE TARGET AND THE GeO TARGET — S5

# FIG. 13

| PREPARING A FIRST TARGET INCLUDING Ge, As, AND Se IN A CHAMBER | S10 |

| PREPARING A SECOND TARGET INCLUDING GeO IN THE CHAMBER | S20 |

| PREPARING A THIRD TARGET INCLUDING In IN THE CHAMBER | S30 |

| SPUTTERING EACH OF THE FIRST TARGET, THE SECOND TARGET, AND THE THIRD TARGET IN A GAS ATMOSPHERE | S40 |

| CONTROLLING A DEPOSITION AMOUNT OF O IN THE GeO OF THE SECOND TARGET | S50 |

| FORMING A MEMORY LAYER INCLUDING Ge, As, Se, In, AND O FROM THE FIRST TARGET, THE SECOND TARGET, AND THE THIRD TARGET | S60 |

# FIG. 14

```
┌──────────────────────────────────────────┐
│   PREPARING A FIRST TARGET INCLUDING      │── S15
│     Ge, As, Se AND In IN A CHAMBER        │
└──────────────────────────────────────────┘
                      │
                      ▼
┌──────────────────────────────────────────┐
│    PREPARING A SECOND TARGET INCLUDING    │── S25
│          GeO IN THE CHAMBER               │
└──────────────────────────────────────────┘
                      │
                      ▼
┌──────────────────────────────────────────┐
│  SPUTTERING EACH OF THE FIRST TARGET AND  │── S35
│  THE SECOND TARGET IN A GAS ATMOSPHERE    │
└──────────────────────────────────────────┘
                      │
                      ▼
┌──────────────────────────────────────────┐
│   CONTROLLING A DEPOSITION AMOUNT OF      │── S45
│    O IN THE GeO OF THE SECOND TARGET      │
└──────────────────────────────────────────┘
                      │
                      ▼
┌──────────────────────────────────────────┐
│     FORMING A MEMORY LAYER INCLUDING      │── S55
│       Ge, As, Se, In, AND O FROM THE      │
│     FIRST TARGET AND THE SECOND TARGET    │
└──────────────────────────────────────────┘
```

# FIG. 15

PREPARING A SINGLE TARGET INCLUDING
Ge, As, Se, In, GeO IN A CHAMBER ── S110

SPUTTERING THE SINGLE TARGET IN
A GAS ATMOSPHERE ── S120

CONTROLLING A DEPOSITION AMOUNT OF
O IN THE GeO OF THE SINGLE TARGET ── S130

FORMING A MEMORY LAYER INCLUDING
Ge, As, Se, In, AND O FROM THE SINGLE TARGET ── S140

# FIG. 16

# FIG. 17

# FIG. 18

# FIG. 19

# FIG. 20

# FIG. 21

# FIG. 22

400

| MEMORY CONTROLLER 401 | | MEMORY APPARATUS 402 |
|---|---|---|

CMD →

ADD →

DATA ↔

P/F ←

MEMORY CELL ARRAY 410

VOLTAGE GENERATOR 420

# FIG. 23

NEUROMORPHIC APPARATUS 500

PROCESSING CIRCUITRY 510

ON-CHIP MEMORY 520

EXTERNAL DEVICE 530